# EUROPEAN PATENT SPECIFICATION

(11) **EP 0 639 799 B1**
(45) Date of publication and mention of the grant of the patent: **27.05.1998**
(21) Application number: 94111961.2
(22) Date of filing: 01.08.1994
(51) Int. Cl.: G03F 7/20

(54) **Apparatus and method for exposing a photosensitive substrate**
Vorrichtung und Verfahren zur Belichtung eines lichtempfindlichen Substrats
Appareil et méthode d'exposition pour substrat photosensible

(30) Priority: 08.08.1993 IL 10661993
(43) Date of publication of application: 22.02.1995
(73) Proprietor: Agfa-Gevaert AG, 51373 Leverkusen (DE)
(72) Inventor: Zertani, Rudolf, Dr., D-55234 Bechtolsheim (DE); Bronstein, Rafail, Kfar Saba 44414 (IL)

(56) References cited:
- EP-A- 0 453 953
- EP-A- 0 489 426
- DE-U- 9 210 460
- FR-A- 2 697 646
- GB-A- 2 080 964
- RESEARCH DISCLOSURE, vol. 252, no. 47, April 1985, HAVANT, GB; page 201; ANONYMOUS: 'two-step photoresist exposure process'

## Description

### FIELD OF THE INVENTION

The present invention relates to apparatus and a method for offset printing plate presensitization.

### BACKGROUND OF THE INVENTION

Offset printing plates are characterized by relatively low sensitivity, as compared with other photosensitive substrates, which requires a relatively high-powered light source and a long exposure time for exposure thereof.

Various techniques are known for presensitization of offset printing plates in order to reduce the high energy requirements for plate exposure. U.S. Patent 4,576,892 describes a method of plate presensitization. European Patent Application EP A 0453957 to Hoescht describes a method and apparatus for printing plate presensitization.

Generally speaking, known techniques for printing plate presensitization affect the sensitivity of the entire printing plate surface and thus increase the presence of spurious information in areas of the plate wherein no information is present.

### SUMMARY OF THE INVENTION

The present invention seeks to provide apparatus and a technique for printing plate presensitization which overcomes disadvantages of the prior art techniques.

There is thus provided in accordance with a preferred embodiment of the present invention a method for exposing a photosensitive substrate including the steps of:
receiving image data for exposing the photosensitive substrate;
employing the image data to presensitize selected regions of the photosensitive substrate in accordance with the image data; and
employing the image data to expose the photosensitive substrate at the selected regions.

Preferably the step of employing the image data to presensitize includes the step of selectively radiating the selected regions in accordance with the image data.

In accordance with a preferred embodiment of the present invention, the step of selectively radiating includes imagewise presensitization of the substrate in accordance with the image data.

Alternatively the step of employing the image data to presensitize includes the step of selectively heating the selected regions in accordance with the image data.

In accordance with a preferred embodiment of the present invention, the step of imagewise presensitization includes pixelwise presensitization.

The substrate is preferably a printing plate.

Preferably, the step of employing the image data to presensitize selected regions of the photosensitive substrate in accordance with the image data operates at a different wavelength from the step of employing the image data to expose the photosensitive substrate at the selected regions.

In accordance with a preferred embodiment of the present invention, the step of employing the image data to presensitize selected regions of the photosensitive substrate in accordance with the image data operates at a longer wavelength from the step of employing the image data to expose the photosensitive substrate at the selected regions.

Preferably, the step of employing the image data to presensitize employs an aiming step which is coordinated with a corresponding aiming step forming part of the step of employing the image data to expose the photosensitive substrate.

In accordance with a preferred embodiment of the present invention, the step of employing the image data to presensitize employs an aiming step which is pixelwise coordinated with a corresponding aiming step forming part of the step of employing the image data to expose the photosensitive substrate.

Additionally in accordance with a preferred embodiment of the present invention there is provided apparatus for exposing a photosensitive substrate including:
apparatus for receiving image data for exposing the photosensitive substrate;
apparatus for employing the image data to presensitize selected regions of the photosensitive substrate in accordance with the image data; and
apparatus for employing the image data to expose the photosensitive substrate at the selected regions.

Preferably, the apparatus for employing the image data to presensitize includes apparatus for selectively radiating the selected regions in accordance with the image data.

In accordance with a preferred embodiment of the present invention, the apparatus for selectively radiating includes apparatus for imagewise presensitization of the substrate in accordance with the image data.

Alternatively, the apparatus for employing the image data to presensitize includes apparatus for selectively heating the selected regions in accordance with the image data.

In accordance with a preferred embodiment of the present invention, the apparatus for imagewise presensitization includes apparatus for pixelwise presensitization.

Preferably, the apparatus for employing the image data to presensitize selected regions of the photosensitive substrate in accordance with the image data operates at a different wavelength from the apparatus for employing the image data to expose the photosensitive substrate at the selected regions.

In accordance with a preferred embodiment of the present invention, the apparatus for employing the image data to presensitize selected regions of the photosensitive substrate in accordance with the image data operates at a longer wavelength from the apparatus for employing the image data to expose the photosensitive substrate at the selected regions.

Preferably, the apparatus for employing the image data to presensitize selected regions includes a laser.

In accordance with a preferred embodiment of the present invention, the aiming of the laser is coordinated with aiming of the apparatus for employing the image data to expose the photosensitive substrate.

Further in accordance with a preferred embodiment of the present invention, the aiming of the laser is coordinated on a pixelwise basis with aiming of the apparatus for employing the image data to expose the photosensitive substrate.

### BRIEF DESCRIPTION OF THE DRAWINGS

The present invention will be understood and appreciated more fully from the following detailed description, taken in conjunction with the drawings in which:
Fig. 1 is a simplified schematic illustration of apparatus for exposing a photosensitive substrate constructed and operative in accordance with a preferred embodiment of the present invention;
Fig. 2 is a simplified schematic illustration of presensitizing and exposing apparatus constructed in accordance with one embodiment of the present invention;
Fig. 3 is a simplified schematic illustration of the optical layout of presensitizing and exposing apparatus useful in the embodiment of Fig. 2;
Fig. 4 is a simplified schematic illustration of presensitizing and exposing apparatus constructed in accordance with another embodiment of the present invention;
Fig. 5 is a simplified schematic illustration of the optical layout of presensitizing and exposing apparatus useful in the embodiment of Fig. 4;
Fig. 6 is a simplified schematic illustration of presensitizing and exposing apparatus constructed in accordance with yet another embodiment of the present invention; and
Fig. 7 is a simplified schematic illustration of the optical layout of a presensitizing and exposing assembly useful in the embodiment of Fig. 6.

### DETAILED DESCRIPTION OF PREFERRED EMBODIMENTS

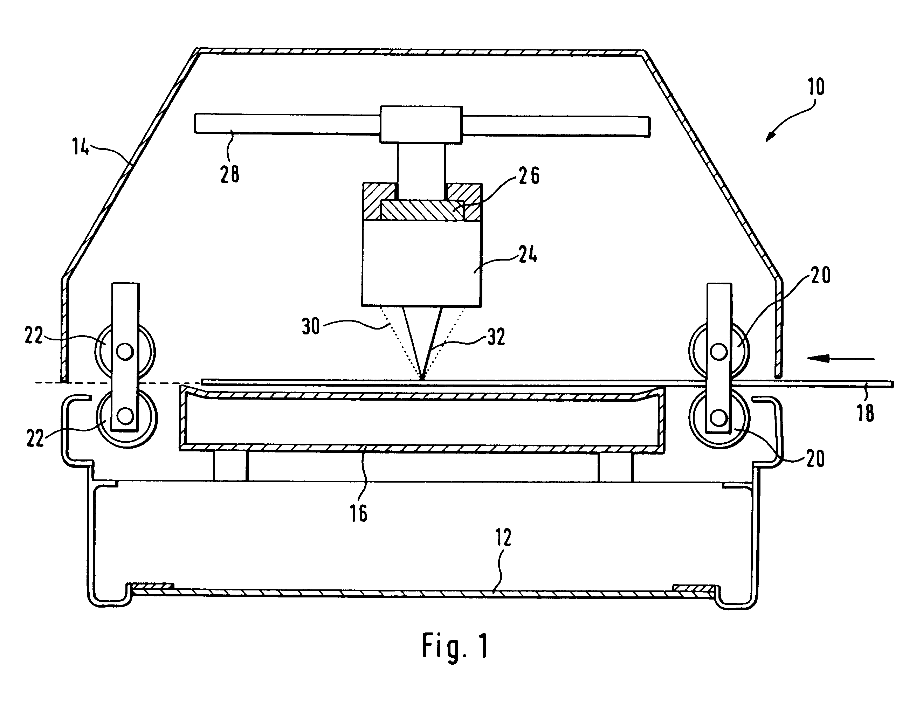

Reference is now made to Fig. 1, which is a simplified schematic illustration of apparatus for exposing a photosensitive substrate constructed and operative in accordance with a preferred embodiment of the present invention.

The apparatus of Fig. 1 comprises a housing 10 including a base portion 12 and a cover portion 14. Mounted on base portion 12 is a plate support table 16 which receives printing plates 18 for exposure. The printing plates 18 are received via input feed rollers 20 and removed from the table via output feed rollers 22.

An exposure head 24 is mounted on mutually perpendicular tracks 26 and 28 defining an X-Y positioner. In accordance with a preferred embodiment of the present invention, head 24 provides at least two preferably coaxial beams of light 30 and 32. Beam 30 may constitute presensitizing illumination and may be provided by an IR semiconductor type laser such as a model LQ1-78, commercially available from Stantel Components Inc., of Thousand Oaks, California or a SDL-2300 series laser diode commercially available from Spectra Diode Labs, San Jose, California, U.S.A. Alternatively other types of IR or other laser sources may be used for this purpose.

It is to be appreciated that beams 30 and 32 need not necessarily be coaxial, provided that beam 30 impinges on a given location on the plate prior to or simultaneously with impingement thereon by beam 32, such that the temperature rise produced at the given location by impingement thereon of beam 30 is not significantly dissipated prior to impingement of beam 32.

Beam 32 may constitute a writing beam and may be of significantly lower energy than beam 30. Beam 32 may be provided by a low power argon ion laser, such as model 161 Manufactured by Spectra Physics, Inc. of Mountain View, California, U.S.A. or a green HeNe laser, such as an 05-GR-193, commercially available from Melles Griot, of Irvine California.

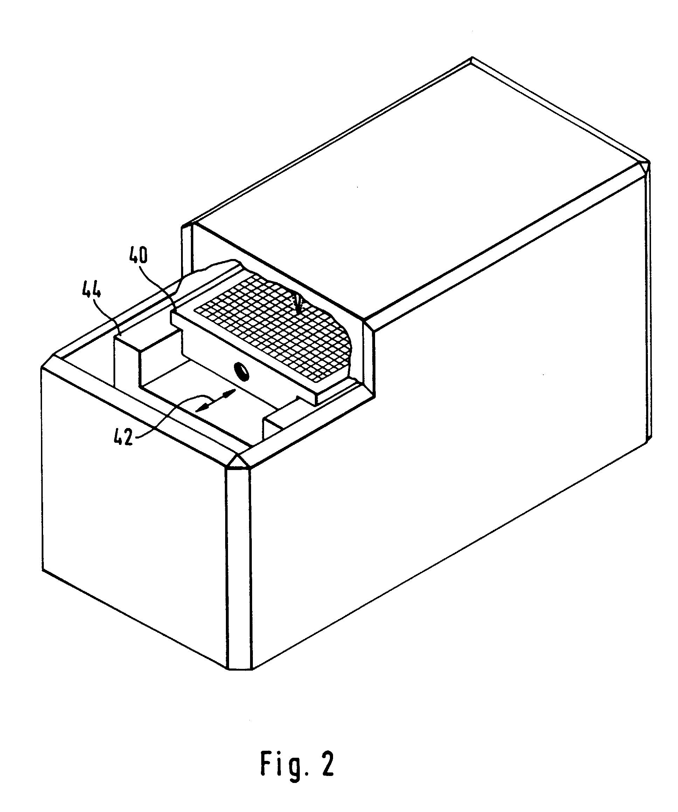

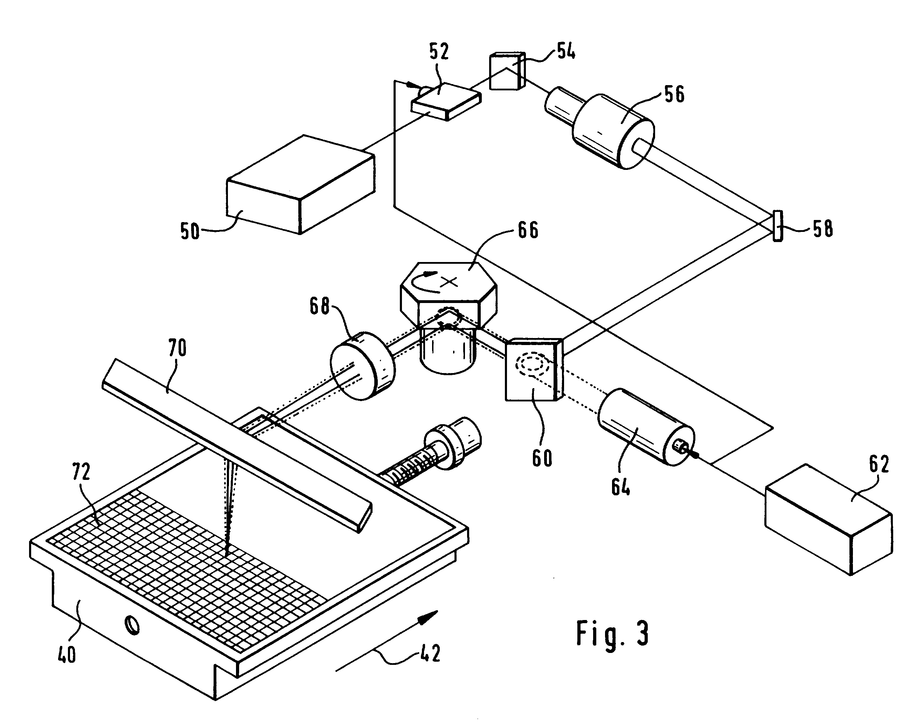

Reference is now made to Fig. 2, which is a simplified schematic illustration of presensitizing and exposing apparatus and to Fig. 3, which is a simplified schematic illustration of the optical layout of presensitizing and exposing apparatus useful in the embodiment of Fig. 2. The apparatus of Fig. 2 is typically of the form of a conventional flatbed printing plate exposure device, such as a Raystar-CTP plotter, commercially available from Scitex Corporation Ltd.

A printing plate support table 40 is arranged to move axially along directions indicated by arrows 42, defined by a track 44.

Fig. 3 illustrates a writing beam laser 50, such as a 05-GR-193, commercially available from Melles Griot, of Irvine California, U.S.A. which outputs a laser beam via an acoustooptic modulator 52, such as a DEL 1206, commercially available form Isomet, Inc. of Springfield, Va., U.S.A.. The modulated laser beam output from modulator 52 is supplied via a folding mirror 54 and a beam expander 56, such as a 09-LBM-015, commercially available from Melles Griot.

The output from beam expander 56 is supplied via a folding mirror 58 to a beam combiner 60, such as a 03 BPL 01 with appropriate coating, commercially available from Melles Griot.

A computer 62, such as a Scitex MicroWhisper employing conventional Scitex exposure programs or any suitable RIP, is operative to provide data to and coordinate the operation of both acousto-optic modulator 52 and a presensitizing beam laser 64. Laser 64 is preferably a LQ1-78, as aforesaid. The output of laser 64 is supplied to combiner 60.

The combined output of combiner 60 is supplied via a polygonal scanning mirror 66 and an f-theta lens 68 as well as a folding mirror 70 onto printing plate or other substrate 72 located on table 40 (Fig. 2).

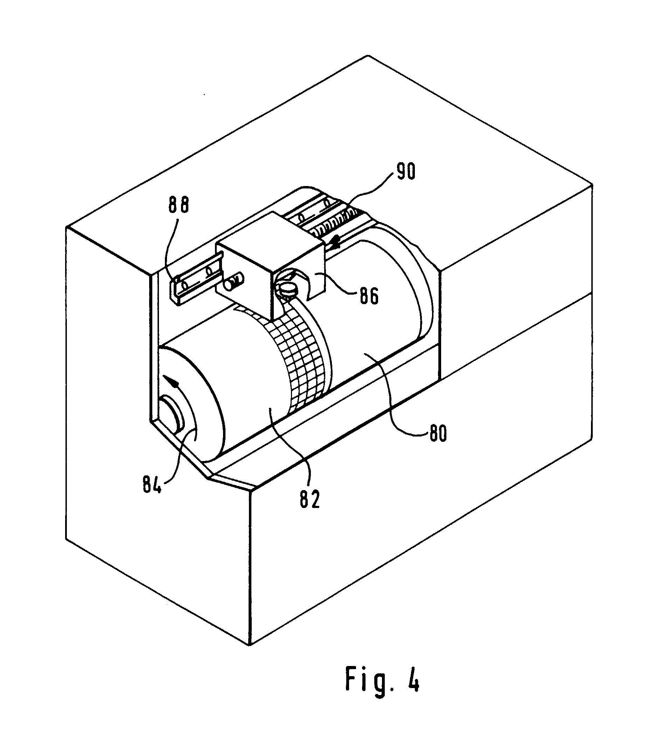

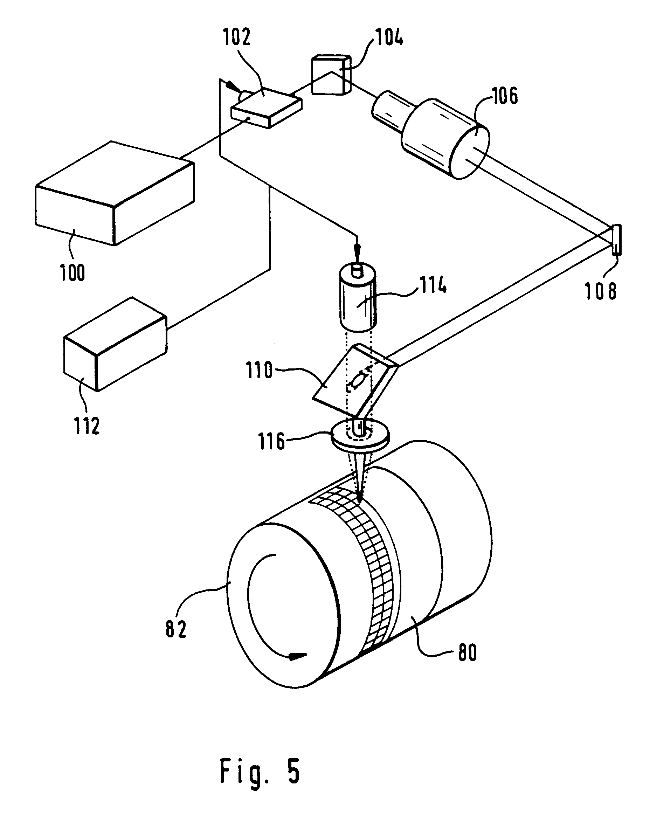

Reference is now made to Fig. 4 which is a simplified schematic illustration of another embodiment of presensitizing and exposing apparatus and to Fig. 5, which is a simplified schematic illustration of the optical layout of presensitizing and exposing apparatus useful in the embodiment of Fig. 4. The apparatus of Fig. 4 is typically of the form of a conventional external drum printing plate exposure device, such as a E-Ray plotter, sold by Scitex Corporation Ltd.

A printing plate 80 is supported on the outside cylindrical surface of a drum 82, which is arranged to rotate in a direction indicated by arrow 84. An exposure head 86 is mounted on a track 88 for axial movement along drum 82, driven by a screw drive 90.

Fig. 5 illustrates a writing beam laser 100, such as a 05-GR-193, commercially available from Melles Griot, of Irvine California, which outputs a laser beam via an acousto-optic modulator 102, such as a Model 1206 commercially available form Isomet, Inc. of Springfield, Va., U.S.A.. The modulated laser beam output from modulator 102 is supplied via a folding mirror 104 and a beam expander 106, such as a 09-LBX-003 commercially available from Melles Griot.

The output from beam expander 106 is supplied via a folding mirror 108 to a beam combiner 110, such as a 03 BPL 01 with appropriate coating, commercially available from Melles Griot.

A computer 112, such as a Scitex MicroWhisper employing conventional Scitex exposure programs or any other suitable RIP, is operative to provide data to and coordinate the operation of both acousto-optic modulator 102 and a presensitizing beam laser 114. Laser 114 is preferably a LQ1-78, as aforesaid. The output of laser 114 is supplied to combiner 110.

The combined output of combiner 110 is focused by a focusing lens 116 onto the printing plate 80, mounted on drum 82 (Fig. 4).

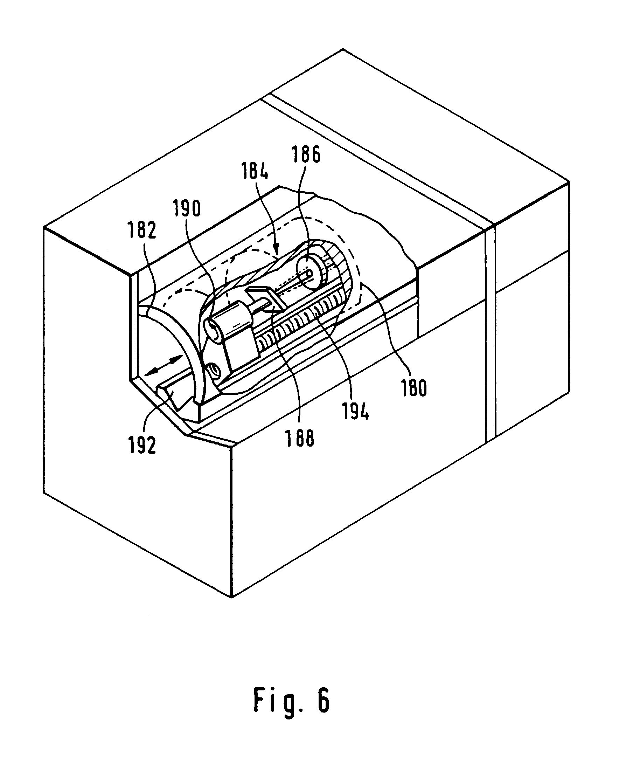

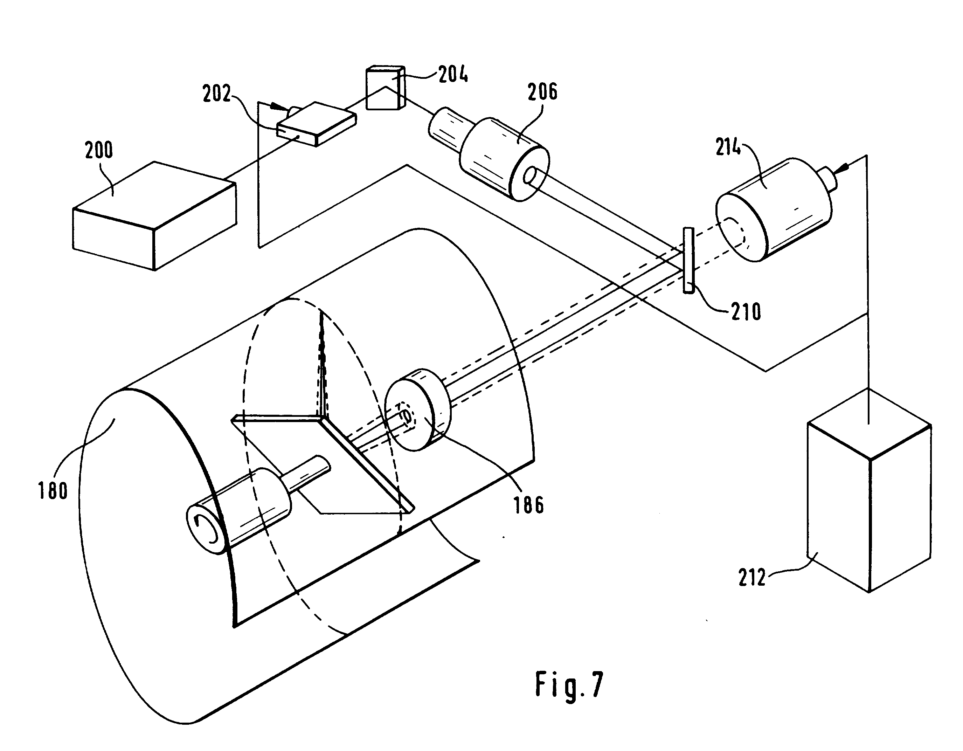

Reference is now made to Fig. 6 which is a simplified schematic illustration of yet another embodiment of presensitizing and exposing apparatus and to Fig. 7, which is a simplified schematic illustration of a presensitizing and exposing assembly useful in the embodiment of Fig. 6. The apparatus of Fig. 6 is typically of the form of a conventional internal drum printing plate exposure device, such as a Doplate 800 plotter, commercially available from Scitex Corporation Ltd.

A printing plate 180 is supported on the inside cylindrical surface of a drum 182. An exposure assembly 184 comprising a focusing lens 186, a spinning mirror 188 and a rotary mirror drive motor 190, is mounted on a track 192, interior of drum 182, for axial movement therealong drum 82, driven by a screw drive 194.

Fig. 7 illustrates a writing beam laser 200, such as a 05-GR-193, commercially available from Melles Griot, of Irvine California, which outputs a laser beam via an acousto-optic modulator 202, such as a Model 1206, commercially available form Isomet, Inc. of Springfield, Va., U.S.A.. The modulated laser beam output from modulator 202 is supplied via a folding mirror 204 and a beam expander 206, such as a 09-LBX-003 commercially available from Melles Griot.

The output from beam expander 206 is supplied via a beam combiner 210, such as a 03 BPL 01 with appropriate coating, commercially available from Melles Griot.

A computer 212, such as a Scitex MicroWhisper employing conventional Scitex exposure programs or any suitable RIP, is operative to provide data to and coordinate the operation of both acousto-optic modulator 202 and a presensitizing beam laser 214. Laser 214 is preferably a LQ1-78, as aforesaid. The output of laser 214 is supplied to combiner 210.

The combined output of combiner 210 is focused by focusing lens 186 onto the printing plate 180, mounted on drum 182 (Fig. 6).

It is appreciated that while in the illustrated embodiments, the impingement of both the presensitizing beam and the writing beam take place at approximately the same time, this need not be the case, provided that the temperature rise produced at the given location by impingement thereon of the presensitizing beam is not significantly dissipated prior to impingement of the writing beam.

It will be appreciated by persons skilled in the art that the present invention is not limited to what has been particularly shown and described hereinabove. Rather the invention is defined only by the scope of the claims which follow:

## Claims

1. A method for exposing a photosensitive substrate comprising the steps of:
receiving image data for exposing the photosensitive substrate;
employing the image data to presensitize selected regions of the photosensitive substrate in accordance with the image data; and
employing the image data to expose the photosensitive substrate at the selected regions.

2. A method according to claim 1 and wherein said step of employing the image data to presensitize comprises the step of selectively radiating said selected regions in accordance with said image data.

3. A method according to claim 1 and wherein said step of employing the image data to presensitize comprises the step of selectively heating said selected regions in accordance with said image data.

4. A method according to claim 2 and wherein said step of selectively radiating comprises imagewise presensitization of the substrate in accordance with said image data.

5. A method according to claim 4 and wherein said step of imagewise presensitization comprises pixelwise presensitization.

6. A method according to any of the preceding claims and wherein said substrate is a printing plate.

7. A method according to any of the preceding claims and wherein said step of employing the image data to presensitize selected regions of the photosensitive substrate in accordance with the image data operates at a different wavelength from said step of employing the image data to expose the photosensitive substrate at the selected regions.

8. A method according to claim 7 and wherein said step of employing the image data to presensitize selected regions of the photosensitive substrate in accordance with the image data operates at a longer wavelength from said step of employing the image data to expose the photosensitive substrate at the selected regions.

9. A method according to any of the preceding claims and wherein the step of employing the image data to presensitize employs an aiming step which is coordinated with a corresponding aiming step forming part of the step of employing the image data to expose the photosensitive substrate.

10. A method according to any of the preceding claims 1 - 8 and wherein the step of employing the image data to presensitize employs an aiming step which is pixelwise coordinated with a corresponding aiming step forming part of the step of employing the image data to expose the photosensitive substrate.

11. Apparatus for exposing a photosensitive substrate comprising:
means for receiving image data for exposing the photosensitive substrate;
means for employing the image data to presensitize selected regions of the photosensitive substrate in accordance with the image data; and
means for employing the image data to expose the photosensitive substrate at the selected regions.

12. Apparatus according to claim 11 and wherein said means for employing the image data to presensitize comprises means for selectively radiating said selected regions in accordance with said image data.

13. Apparatus according to claim 11 and said wherein said means for employing the image data to presensitize comprises means for selectively heating said selected regions in accordance with said image data.

14. Apparatus according to claim 12 and wherein said means for selectively radiating comprises means for imagewise presensitization of the substrate in accordance with said image data.

15. Apparatus according to claim 14 and wherein said means for imagewise presensitization comprises means for pixelwise presensitization.

16. Apparatus according to any of the preceding claims 11 - 15 and wherein said substrate is a printing plate.

17. Apparatus according to any of the preceding claims and wherein said means for employing the image data to presensitize selected regions of the photosensitive substrate in accordance with the image data operates at a different wavelength from said means for employing the image data to expose the photosensitive substrate at the selected regions.

18. Apparatus according to claim 17 and wherein said means for employing the image data to presensitize selected regions of the photosensitive substrate in accordance with the image data operates at a longer wavelength from said means for employing the image data to expose the photosensitive substrate at the selected regions.

19. Apparatus according to any of claims 11 - 17 and wherein said means for employing the image data to presensitize selected regions comprises a laser.

20. Apparatus according to claim 19 and wherein the aiming of said laser is coordinated with aiming of said means for employing the image data to expose the photosensitive substrate.

21. Apparatus according to claim 20 and wherein the aiming of said laser is coordinated on a pixelwise basis with aiming of said means for employing the image data to expose the photosensitive substrate.

## Patentansprüche

1. Verfahren zum Belichten eines lichtempfindlichen Substrats, umfassend die Schritte:
Empfangen von Bilddaten zur Belichtung des lichtempfindlichen Substrats;
Verwenden der Bilddaten zum Vorsensibilisieren ausgewählter Bereiche des lichtempfindlichen Substrats im Einklang mit den Bilddaten; und
Verwenden der Bilddaten zum Belichten des lichtempfindlichen Substrats in den ausgewählten Bereichen.

2. Verfahren gemäß Anspruch 1, wobei der Schritt des Verwendens der Bilddaten zum Vorsensibilisieren den Schritt des selektiven Bestrahlens der ausgewählten Bereiche im Einklang mit den Bilddaten umfaßt.

3. Verfahren gemäß Anspruch 1, wobei der Schritt des Verwendens der Bilddaten zum Vorsensibilisieren den Schritt des selektiven Erhitzens der ausgewählten Bereiche im Einklang mit den Bilddaten umfaßt.

4. Verfahren gemäß Anspruch 2, wobei der Schritt des selektiven Bestrahlens die bildartige Vorsensibilisierung des Substrats im Einklang mit den Bilddaten umfaßt.

5. Verfahren gemäß Anspruch 4, wobei der Schritt der bildartigen Vorsensibilisierung die pixelweise Vorsensibilisierung umfaßt.

6. Verfahren gemäß einem der vorstehenden Ansprüche, wobei das Substrat eine Druckplatte ist.

7. Verfahren gemäß einem der vorstehenden Ansprüche, wobei man beim Schritt des Verwendens der Bilddaten zum Vorsensibilisieren ausgewählter Bereiche des lichtempfindlichen Substrats im Einklang mit den Bilddaten bei einer anderen Wellenlänge arbeitet als beim Schritt des Verwendens der Bilddaten zum Belichten des lichtempfindlichen Substrats in den ausgewählten Bereichen.

8. Verfahren gemäß Anspruch 7, wobei man beim Schritt des Verwendens der Bilddaten zum Vorsensibilisieren ausgewählter Bereiche des lichtempfindlichen Substrats im Einklang mit den Bilddaten bei einer längeren Wellenlänge arbeitet als beim Schritt des Verwendens der Bilddaten zum Belichten des lichtempfindlichen Substrats in den ausgewählten Bereichen.

9. Verfahren gemäß einem der vorstehenden Ansprüche, wobei der Schritt des Verwendens der Bilddaten zum Vorsensibilisieren einen Zielschritt umfaßt, der mit einem entsprechenden Zielschritt, der Bestandteil des Schritts des Verwendens der Bilddaten zum Belichten des lichtempfindlichen Substrats ist, koordiniert ist.

10. Verfahren gemäß einem der vorstehenden Ansprüche 1 bis 8, wobei der Schritt des Verwendens der Bilddaten zum Vorsensibilisieren einen Zielschritt umfaßt, der mit einem entsprechenden Zielschritt, der Bestandteil des Schritts des Verwendens der Bilddaten zum Belichten des lichtempfindlichen Substrats ist, pixelweise koordiniert ist.

11. Vorrichtung zum Belichten eines lichtempfindlichen Substrats, umfassend:
eine Einrichtung zum Empfangen von Bilddaten zur Belichtung des lichtempfindlichen Substrats;
eine Einrichtung zum Verwenden der Bilddaten zum Vorsensibilisieren ausgewählter Bereiche des lichtempfindlichen Substrats im Einklang mit den Bilddaten; und
eine Einrichtung zum Verwenden der Bilddaten zum Belichten des lichtempfindlichen Substrats in den ausgewählten Bereichen.

12. Vorrichtung gemäß Anspruch 11, wobei die Einrichtung zum Verwenden der Bilddaten zum Vorsensibilisieren eine Einrichtung zum selektiven Bestrahlen der ausgewählten Bereiche im Einklang mit den Bilddaten umfaßt.

13. Vorrichtung gemäß Anspruch 11, wobei die Einrichtung zum Verwenden der Bilddaten zum Vorsensibilisieren eine Einrichtung zum selektiven Erhitzen der ausgewählten Bereiche im Einklang mit den Bilddaten umfaßt.

14. Vorrichtung gemäß Anspruch 12, wobei die Einrichtung zum selektiven Bestrahlen eine Einrichtung zum bildartigen Vorsensibilisieren des Substrats im Einklang mit den Bilddaten umfaßt.

15. Vorrichtung gemäß Anspruch 14, wobei die Einrichtung zum bildartigen Vorsensibilisieren eine Einrichtung zum pixelweisen Vorsensibilisieren umfaßt.

16. Vorrichtung gemäß einem der vorstehenden Ansprüche 11 bis 15, wobei das Substrat eine Druckplatte ist.

17. Vorrichtung gemäß einem der vorstehenden Ansprüche, wobei die Einrichtung zum Verwenden der Bilddaten zum Vorsensibilisieren ausgewählter Bereiche des lichtempfindlichen Substrats im Einklang mit den Bilddaten bei einer anderen Wellenlänge arbeitet als die Einrichtung zum Verwenden der Bilddaten zum Belichten des lichtempfindlichen Substrats in den ausgewählten Bereichen.

18. Vorrichtung gemäß Anspruch 17, wobei die Einrichtung zum Verwenden der Bilddaten zum Vorsensibilisieren ausgewählter Bereiche des lichtempfindlichen Substrats im Einklang mit den Bilddaten bei einer längeren Wellenlänge arbeitet als die Einrichtung zum Verwenden der Bilddaten zum Belichten des lichtempfindlichen Substrats in den ausgewählten Bereichen.

19. Vorrichtung gemäß einem der Ansprüche 11 bis 17, wobei die Einrichtung zum Verwenden der Bilddaten zum Vorsensibilisieren ausgewählter Bereiche einen Laser umfaßt.

20. Vorrichtung gemäß Anspruch 19, wobei die Zielausrichtung des Lasers mit der Zielausrichtung der Einrichtung zum Verwenden der Bilddaten zum Belichten des lichtempfindlichen Substrats koordiniert ist.

21. Vorrichtung gemäß Anspruch 20, wobei die Zielausrichtung des Lasers auf einer pixelweisen Basis mit der Zielausrichtung der Einrichtung zum Verwenden der Bilddaten zum Belichten des lichtempfindlichen Substrats koordiniert ist.

## Revendications

1. Procédé pour exposer un substrat photosensible comprenant les étapes de :
réception de données d'image pour exposer le substrat photosensible ;
emploi des données d'image pour présensibiliser des régions choisies du substrat photosensible selon les données d'image ; et
emploi des données d'image pour exposer le substrat photosensible dans les régions choisies.

2. Procédé selon la revendication 1 et où ladite étape d'emploi des données d'image pour présensibiliser comprend l'étape d'irradiation sélective desdites régions choisies selon lesdites données d'image.

3. Procédé selon la revendication 1 et où ladite étape d'emploi des données d'image pour présensibiliser comprend l'étape de chauffage sélectif desdites régions choisies selon lesdites données d'image.

4. Procédé selon la revendication 2 et où ladite étape d'irradiation sélective comprend la présensibilisation sous forme d'image du substrat selon lesdites données d'image.

5. Procédé selon la revendication 4 et où ladite étape de présensibilisation sous forme d'image comprend une présensibilisation sous forme de pixels.

6. Procédé selon l'une quelconque des revendications précédentes et où ledit substrat est une plaque d'impression.

7. Procédé selon l'une quelconque des revendications précédentes et où ladite étape d'emploi des données d'image pour présensibiliser des régions choisies du substrat photosensible selon les données d'image opère à une longueur d'onde différente de ladite étape d'emploi des données d'image pour exposer le substrat photosensible dans les régions choisies.

8. Procédé selon la revendication 7 et où ladite étape d'emploi des données d'image pour présensibiliser des régions choisies du substrat photosensible selon les données d'image opère à une plus grande longueur d'onde que ladite étape d'emploi des données d'image pour exposer le substrat photosensible dans les régions choisies.

9. Procédé selon l'une quelconque des revendications précédentes et où l'étape d'emploi des données d'image pour présensibiliser emploie une étape de pointage qui est coordonnée avec une étape de pointage correspondante qui fait partie de l'étape d'emploi des données d'image pour exposer le substrat photosensible.

10. Procédé selon l'une quelconque des revendications 1-8 précédentes et où l'étape d'emploi des données d'image pour présenbiliser emploie une étape de pointage qui est coordonnée sous forme de pixels avec une étape de pointage correspondante qui fait partie de l'étape d'emploi des données d'image pour exposer le substrat photosensible.

11. Appareil pour exposer un substrat photosensible comprenant :
un moyen pour recevoir des données d'image pour exposer le substrat photosensible ;
un moyen pour employer les données d'image pour présensibiliser des régions choisies du substrat photosensible selon les données d'image ; et
un moyen pour employer les données d'image pour exposer le substrat photosensible dans les régions choisies.

12. Appareil selon la revendication 11 et où ledit moyen pour employer les données d'image pour présensibiliser comprend un moyen pour irradier sélectivement lesdites régions choisies selon lesdites données d'image.

13. Appareil selon la revendication 11 et où ledit moyen pour employer les données d'image pour présensibiliser comprend un moyen pour chauffer sélectivement lesdites régions choisies selon lesdites données d'image.

14. Appareil selon la revendication 12 et où ledit moyen pour irradier sélectivement comprend un moyen pour la présensibilisation du substrat sous forme d'image selon lesdites données d'image.

15. Appareil selon la revendication 14 et où ledit moyen pour la présenbilisation sous forme d'image comprend un moyen pour la présensibilisation sous forme de pixels.

16. Appareil selon l'une quelconque des revendications 11-15 précédentes et où ledit substrat est une plaque d'impression.

17. Appareil selon l'une quelconque des revendications précédentes et où ledit moyen pour employer les données d'image pour présensibiliser des régions choisies du substrat photosensible selon les données d'image opère à une longueur d'onde différente dudit moyen pour employer les données d'image pour exposer le substrat photosensible dans les régions choisies.

18. Appareil selon la revendication 17 et où ledit moyen pour employer les données d'image pour présensibiliser des régions choisies du substrat photosensible selon les données d'image opère à une plus grande longueur d'onde que ledit moyen pour employer les données d'image pour exposer le substrat photosensible dans les régions choisies.

19. Appareil selon l'une quelconque des revendications 11-17 et où ledit moyen pour employer les données d'image pour présensibiliser des régions choisies comprend un laser.

20. Appareil selon la revendication 19 et où le pointage dudit laser est coordonné avec le pointage dudit moyen pour employer les données d'image pour exposer le substrat photosensible.

21. Appareil selon la revendication 20 et où le pointage dudit laser est coordonné sous forme de pixels avec le pointage dudit moyen pour employer les données d'image pour exposer le substrat photosensible.
